(19)

Europäisches
Patentamt

European
Patent Office

Office européen
des brevets

(11) **EP 4 312 379 A1**

(12) **DEMANDE DE BREVET EUROPEEN**

(43) Date de publication:
**31.01.2024  Bulletin 2024/05**

(21) Numéro de dépôt: **22306115.1**

(22) Date de dépôt: **27.07.2022**

(51) Classification Internationale des Brevets (IPC):
***H03M 1/12*** *(2006.01)*

(52) Classification Coopérative des Brevets (CPC):
**H03M 1/1285; H03M 1/126**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(71) Demandeur: **BULL SAS**
**78340 Les Clayes-Sous-Bois (FR)**

(72) Inventeur: **CHARTON, Philippe**
**13100 AIX EN PROVENCE (FR)**

(74) Mandataire: **IPAZ**
**Bâtiment Platon**
**Parc Les Algorithmes**
**91190 Saint-Aubin (FR)**

(54)  **PROCÉDÉ, PROGRAMME D'ORDINATEUR ET DISPOSITIF DE NUMÉRISATION DE SIGNAUX**

(57)   L'invention concerne un procédé de procédé (100) numérisation de signaux se trouvant dans une bande de fréquences, dite bande utile, comprenant les étapes suivantes :
- au moins deux numérisations (102,104) des signaux de ladite bande utile à des fréquences d'échantillonnage différentes pour obtenir deux numérisations provisoires pour ladite bande utile, et

-obtention (112) d'une numérisation définitive pour ladite bande utile en éliminant dans l'une desdites numérisations provisoires chaque fréquence, ou raie de fréquence, qui n'apparait pas dans l'autre desdites numérisations provisoires.

Elle concerne également un programme d'ordinateur et un dispositif mettant en œuvre un tel procédé.

100

| Filtrage passe-bande | ⟍114 |

↓

| Première numérisation de la bande utile, et mémorisation de la première numérisation provisoire | ⟍102 |

↓

| Deuxième numérisation de la bande utile, et mémorisation de la deuxième numérisation provisoire | ⟍104 |

↓

| Analyse de la première numérisation provisoire pour en détecter les composantes fréquentielles | ⟍106 |

↓

| Analyse de la deuxième numérisation provisoire pour en détecter les composantes fréquentielles | ⟍108 |

↓

| Identification des composantes fréquentielles communes aux deux numérisations provisoires | ⟍110 |

↓

| Fourniture de la numérisation définitive des signaux | ⟍112 |

## FIG. 1

EP 4 312 379 A1

## Description

La présente invention concerne un procédé de numérisation de signaux analogiques se trouvant dans une bande de fréquences. Elle concerne également un programme d'ordinateur et un dispositif mettant en œuvre un tel procédé.

Le domaine de l'invention est de manière générale le domaine de la numérisation de signaux analogiques hautes fréquences.

## État de la technique

La numérisation de signaux se trouvant dans une bande de fréquence peut se faire grâce à des convertisseurs analogiques numériques, CAN (ADC en anglais), comprenant des échantillonneurs bloqueurs. Grâce aux progrès des échantillonneurs bloqueurs, les bandes passantes des CAN sont de plus en plus étendues et permettent maintenant de traiter la numérisation directe de signaux analogiques jusqu'à des fréquences de 20 GHz. A ces très hautes fréquences, les performances d'élimination des raies parasites hors harmoniques deviennent très efficaces, et permettent d'obtenir des dynamiques instantanées supérieures à 60 dB. Par contre les premiers harmoniques des signaux numérisés se replient dans la bande de fréquence en créant des raies parasites et limitent ainsi la dynamique instantanée à 30 ou 40 dB. Par conséquent, la dynamique instantanée des solutions existantes à très hautes fréquences, en particulier à partir de la dizaine de GHz, est limitée par ces repliements d'harmoniques à 30 ou 40 dB.

Un but de la présente invention est de remédier à cet inconvénient.

Un autre but de l'invention est de proposer une solution de numérisation de signaux dans une bande de fréquences dont la dynamique instantanée est améliorée.

Un autre but de l'invention est de proposer une solution de numérisation de signaux dans une bande de fréquences dont la dynamique instantanée n'est pas, ou moins, impactée par les harmoniques des signaux numérisés.

## Exposé de l'invention

L'invention propose d'atteindre au moins l'un des buts précités par un procédé de numérisation de signaux se trouvant dans une bande de fréquences, dite bande utile, comprenant les étapes suivantes :

- au moins deux numérisations des signaux de ladite bande utile à des fréquences d'échantillonnage différentes pour obtenir deux numérisations provisoires pour ladite bande utile, et
- obtention d'une numérisation définitive pour ladite bande utile en éliminant dans l'une desdites numérisations provisoires chaque fréquence, ou raie de fréquence, qui n'apparait pas dans l'autre desdites numérisations provisoires.

Ainsi, le procédé selon l'invention propose de réaliser au moins deux numérisations des signaux se trouvant dans la bande utile à des fréquences d'échantillonnage différentes. Ensuite, l'invention propose d'obtenir une numérisation finale des signaux de la bande utile, en ne conservant que les signaux de mêmes fréquences dans les deux numérisations provisoires. Autrement dit, une fréquence qui n'apparait que dans une seule des deux numérisations provisoires n'est pas conservée et ne fera pas partie de la numérisation définitive.

Lorsqu'un signal analogique d'une fréquence donnée est numérisé, le signal numérisé comporte une raie à ladite fréquence donnée. Par ailleurs, les harmoniques qui apparaissent lors de la numérisation d'un tel signal, et en particulier lors de son échantillonnage, et qui se replient dans la bande, ont des fréquences qui, elles, dépendent de la fréquence d'échantillonnage. Le fait de réaliser au moins deux numérisations à des fréquences d'échantillonnage différentes, il est possible de discriminer le signal principal des harmoniques et de les éliminer. Ainsi, l'invention permet d'obtenir une solution de numérisation de signaux dans une bande de fréquence dont la dynamique instantanée est améliorée comparée aux solutions actuelles, ou du moins, n'est pas, ou moins, impactée par les harmoniques des signaux numérisés, en particulier dans les très hautes fréquences, c'est-à-dire à partir du GHz et en particulier de la dizaine de GHz.

Dans la présente demande, par très haute fréquence, on entend une fréquence supérieure ou égale au GHz, et plus particulièrement de l'ordre de 10 GHz.

Une bande utile est définie par une fréquence inférieure, notée $F_{inf}$, et une fréquence supérieure, noté $F_{sup}$, et au moins une fréquence comprise entre la fréquence inférieure $F_{inf}$ et la fréquence supérieure $F_{sup}$.

Suivant des modes de réalisation le procédé selon l'invention peut comprendre une étape de filtrage passe bande pour éliminer les signaux dont la fréquence ne se trouve pas dans la bande utile.

Un tel filtrage passe bande peut se faire de manière conventionnelle avec un filtre passe bande, centré sur la bande utile et dont la largeur correspond à la largeur de la bande utile.

Alternativement, un tel filtrage passe bande peut être réalisé par une combinaison d'un filtre passe bas avec un filtre passe haut.

Suivant des modes de réalisation, au moins une, en particulier chaque, fréquence d'échantillonnage doit être supérieure au double de la largeur de la bande utile.

Ainsi, lorsque la bande utile est définie par une fréquence inférieure $F_{inf}$ et une fréquence supérieure $F_{sup}$, alors chaque fréquence d'échantillonnage $F_{éch1}$ et $F_{éch2}$ est choisie telle que :

$$F_{\text{éch1}} > 2(F_{\text{sup}} - F_{\text{inf}})$$

$$F_{\text{éch2}} > 2(F_{\text{sup}} - F_{\text{inf}})$$

Comme indiqué plus haut, les numérisations provisoires, obtenues à des fréquences d'échantillonnage différentes, ont pour but de discriminer les harmoniques créés par la numérisation pour chaque signal analogique dont la fréquence se trouve dans la bande utile. Pour ce faire, les deux fréquences d'échantillonnage doivent être différentes l'une de l'autre car elles influent sur la fréquence des harmoniques créés lors de la numérisation. Cette différence, noté $D_{\text{éch}}$, doit être suffisante pour discriminer les harmoniques créés lors de la numérisation

Suivant des modes de réalisation, la différence entre les fréquences d'échantillonnage est supérieure ou égale au pas de précision en fréquence des signaux numérisés de sorte à discriminer deux raies de fréquences différentes.

Selon un autre aspect de l'invention, il est proposé un programme d'ordinateur comprenant des instructions exécutables qui, lorsqu'elles sont exécutées par un appareil informatique, mettent en en œuvre toutes les étapes du procédé de numérisation selon l'invention

Le programme d'ordinateur peut être en tout langage informatique, tel que par exemple en langage machine, en C, C++, JAVA, Python, etc.

Selon un autre aspect de l'invention, il est proposé un dispositif de numérisation comprenant des moyens configurés pour mettre en œuvre toutes les étapes du procédé de numérisation selon l'invention.

Le dispositif selon l'invention peut être tout type d'appareil tel qu'un serveur, un ordinateur, une tablette, un calculateur, un processeur, une puce informatique, programmé pour mettre en œuvre le procédé selon l'invention, par exemple en exécutant le programme d'ordinateur selon l'invention.

Le dispositif selon l'invention peut comprendre, en termes de moyens techniques, une combinaison quelconque des caractéristiques décrites plus haut en relation avec le procédé selon l'invention.

En particulier, suivant des modes de réalisation, le dispositif selon l'invention peut comprendre un unique convertisseur analogique-numérique, CAN. Dans ce cas, les au moins deux numérisations peuvent être réalisées par cet unique convertisseur analogique-numérique utilisé à tour de rôle.

Suivant des modes de réalisation alternatifs, le dispositif selon l'invention peut comprendre un convertisseur analogique numérique pour chaque numérisation. Dans ce cas, caque numérisation est réalisée par un CAN qui est dédié à ladite numérisation.

Dans ce cas, les au moins deux numérisations peuvent être réalisées à tour de rôle, ou préférentiellement de manière simultanée.

Suivant un exemple de réalisation nullement limitatif, le, ou au moins un, convertisseur analogique numérique peut comprendre un échantillonneur bloqueur.

Le dispositif selon l'invention peut en outre comprendre un module agencé ou configuré pour réaliser une analyse fréquentielle d'une numérisation provisoire en vue d'en extraire les fréquences présentes dans ladite numérisation. Un tel module d'analyse peut réaliser une transformée de Fourier de ladite numérisation provisoire et réaliser une analyse spectrale de la transformée de Fourier de ladite numérisation provisoire en vue d'en extraire les différentes composantes fréquentielles.

Un tel module peut par exemple comprendre un analyseur de fréquence.

Le dispositif selon l'invention peut comprendre un unique module d'analyse utilisé à tour de rôle pour chaque numérisation provisoire.

Alternativement, le dispositif selon l'invention peut comprendre un module d'analyse pour chaque numérisation provisoire de sorte que l'analyse fréquentielle de chaque numérisation peut être réalisée à tour de rôle ou, préférentiellement, de manière simultanée.

Le dispositif selon l'invention peut en outre comprendre un module agencé ou configuré pour éliminer dans l'une des numérisations provisoires chaque fréquence, ou raie de fréquence, qui n'apparait pas dans l'autre desdites numérisations provisoires. Un tel module peut réaliser une suppression de composante(s) fréquentielle(s) identifiée(s) dans l'une des numérisations provisoires, par exemple par filtrage ou tout moyen d'élimination d'une composante fréquentielle.

Au moins l'un des modules décrits ci-dessus peut être un module matériel, tel qu'un serveur, un ordinateur, une tablette, un calculateur, un processeur, une puce informatique.

Au moins l'un des modules décrits ci-dessus peut être un module logiciel, tel qu'un programme d'ordinateur, une application, etc.

Au moins l'un des modules décrits ci-dessus peut être une combinaison d'au moins un module logiciel et d'au moins un module matériel.

Au moins l'un des modules décrits ci-dessus peut être un module individuel et indépendant des autres modules.

Au moins deux des modules décrits ci-dessus peuvent être intégrés au sein d'un même module logiciel ou matériel.

## Description des figures et modes de réalisation

D'autres avantages et caractéristiques apparaîtront à l'examen de la description détaillée de modes de réalisation nullement limitatifs, et des dessins annexés sur lesquels :

- la FIGURE 1 est une représentation schématique d'un premier exemple de réalisation non limitatif d'un procédé selon l'invention ;

- la FIGURE 2 est une représentation schématique d'un exemple de réalisation non limitatif d'un dispositif selon l'invention ;
- la FIGURE 3 est une représentation schématique d'un autre exemple de réalisation non limitatif d'un dispositif selon l'invention ; et
- la FIGURES 4a-4e donnent un exemple non limitatif de numérisation d'une bande utile selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

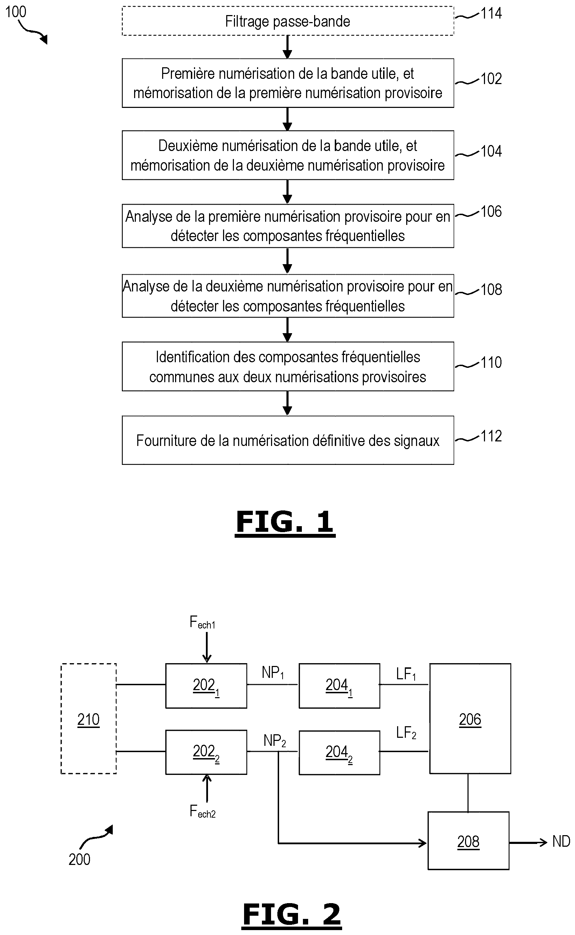

La FIGURE 1 est une représentation schématique d'un premier exemple de réalisation non limitatif d'un procédé selon la présente invention.

Le procédé 100 de la FIGURE 1 peut être utilisé pour la numérisation de tout type de signaux, et en particulier de signaux se trouvant dans une bande de fréquences, dite bande utile, en particulier dans les très hautes fréquences, c'est-à-dire à partir de quelques GHz, ou de la dizaine de GHz.

Suivant un exemple de réalisation non limitatif, et sans perte de généralité, la bande utile peut être la bande fréquentielle 6GHz-9GHz. Ainsi, la fréquence inférieure $F_{inf}$ de la bande utile est égale à 6GHz et la fréquence supérieure $F_{sup}$ de la bande utile est égale à 9GHz.

Le procédé 100 comprend une étape 102 réalisant une première numérisation des signaux se trouvant dans la bande utile, à une première fréquence d'échantillonnage, notée $F_{éch1}$. Cette première fréquence d'échantillonnage est choisie de telle que sorte que $F_{éch1} > 2(F_{sup} - F_{inf})$. Cette première numérisation fournit une première numérisation provisoire de la bande utile comprenant les signaux analogiques réellement présents dans la bande utile et des harmoniques de ces signaux analogiques qui se sont repliés dans la bande utile lors de la numérisation. Or, sans connaître les fréquences des signaux analogiques initialement présents dans la bande utile, il n'est pas possible de discriminer ces harmoniques dans la première numérisation. Cette première numérisation provisoire est mémorisée lors de l'étape 102.

Le procédé 100 comprend une étape 104 réalisant une deuxième numérisation des signaux se trouvant dans la bande utile, à une deuxième fréquence d'échantillonnage, notée $F_{éch2}$, différente de la première fréquence d'échantillonnage $F_{éch1}$. Cette deuxième fréquentielle d'échantillonnage est choisie de telle que sorte que $F_{éch2} > 2(F_{sup} - F_{inf})$, et $F_{éch2} \neq F_{éch1}$. Cette deuxième numérisation fournit une deuxième numérisation provisoire de la bande utile comprenant les signaux analogiques réellement présents dans la bande utile et des harmoniques de ces signaux analogiques qui se sont repliés dans la bande utile lors de la numérisation. Or, tout comme pour la première numérisation, sans connaître les fréquences des signaux analogiques initialement présents dans la bande utile, il n'est pas possible de discriminer ces harmoniques dans la deuxième numérisation. Cette deuxième numérisation provisoire est mémorisée lors de l'étape 104.

Lors d'une étape 106, la première numérisation provisoire est analysée, par exemple par un analyseur de fréquence. Ainsi, chaque composante fréquentielle se trouvant dans la première numérisation est identifiée.

Lors d'une étape 108, la deuxième numérisation provisoire est analysée, par exemple par un analyseur de fréquence, à l'instar de la première numérisation, pour identifier chaque composante fréquentielle se trouvant dans la deuxième numérisation est identifiée.

Lors d'une étape 110, les composantes fréquentielles identifiées dans la première numérisation provisoire sont comparées aux composantes fréquentielles identifiées dans la deuxième numérisation provisoire, pour identifier les composantes fréquentielles communes auxdites première et deuxième numérisations provisoires. Chaque composante fréquentielle commune aux deux numérisations provisoires, c'est-à-dire chaque composante fréquentielle de même fréquence dans les deux numérisations provisoires, correspond à un signal analogique se trouvant dans la bande utile.

Une composante fréquentielle qui se trouve uniquement dans la première numérisation provisoire, mais qui ne se trouve pas dans la deuxième numérisation provisoire, correspond à un harmonique qui s'est replié dans la bande utile lors de la première numérisation : cette composante ne correspond donc pas à un signal analogique réellement présent dans la bande utile et doit être éliminée. De manière similaire, une composante fréquentielle qui se trouve uniquement dans la deuxième numérisation provisoire, mais qui ne se trouve pas dans la première numérisation provisoire, correspond à un harmonique qui s'est replié dans la bande utile lors de la deuxième numérisation : cette composante ne correspond donc pas à un signal réellement présent dans la bande utile et doit être éliminé.

L'étape 110 fournit donc une liste de composantes fréquentielles communes aux deux numérisations provisoires : ces composantes fréquentielles communes doivent être conservées. Alternativement, ou en plus, l'étape 110 peut fournir une liste de composantes fréquentielles non-communes aux deux numérisations provisoires et qui se trouvent uniquement dans l'une des première et deuxième numérisations provisoires : ces composantes fréquentielles non-communes doivent être éliminées.

Le procédé 100 comprend une étape 112 qui fournit une numérisation définitive de la bande utile, c'est-à-dire des signaux se trouvant dans la bande utile. Pour ce faire, l'étape 112 élimine dans la première numérisation provisoire, toutes les composantes non-communes identifiées lors de l'étape 110 qui :

- se trouvent dans ladite première numérisation provisoire, et
- ne se trouvent pas dans la deuxième numérisation provisoire.

Alternativement, toutes les composantes communes, identifiées lors de l'étape 110, sont conservées dans la première numérisation provisoire.

Cette opération peut aussi être réalisée en partant de la deuxième numérisation provisoire et en éliminant, de ladite deuxième numérisation provisoire, toutes les composantes fréquentielles qui se trouvent dans ladite deuxième numérisation provisoire mais qui ne se trouvent pas dans la première numérisation provisoire.

Le procédé 100 peut en outre comprendre une étape 114, optionnelle, de filtrage passe bande, pour sélectionner les signaux se trouvant dans la bande utile. Cette étape 114 est réalisée avant les étapes 102 et 104 de numérisation et fournit les signaux à numériser en éliminant tous les signaux analogiques qui ne trouvent pas dans la bande utile.

Dans l'exemple décrit, les étapes 102 et 104 sont réalisées à tour de rôle. Suivant des modes de réalisation, les étapes 102 et 104 peuvent être réalisées au moins en partie simultanément.

Dans l'exemple décrit, les étapes 106 et 108 sont réalisées à tour de rôle. Suivant des modes de réalisation, les étapes 106 et 108 peuvent être réalisées au moins en partie simultanément.

Par ailleurs, les étapes 102-108 peuvent être réalisées dans un autre ordre que celui décrits en relation avec la FIGURE 1.

Le procédé 100, et plus généralement l'invention, peut être utilisée pour la numérisation de signaux radiofréquences, tels que des signaux de communication, des signaux d'identification, des signaux de localisation, des signaux de détection, etc.

Le procédé 100, et plus généralement l'invention, permet de réaliser une numérisation directe des signaux se trouvant dans une bande de fréquence, tout en conservant les dynamiques instantanées supérieures à 60 dB.

La FIGURE 2 est une représentation schématique d'un premier exemple de réalisation non limitatif d'un dispositif selon la présente invention.

Le dispositif 200 de la FIGURE 2 peut être utilisé pour mettre en œuvre tout procédé selon l'invention, et en particulier le procédé 100 de la FIGURE 1.

Le dispositif 200 comprend un premier module de numérisation $202_1$, comprenant, ou consistant en, un échantillonneur bloqueur. Ce module de numérisation $202_1$ est configuré pour réaliser une numérisation de la bande utile à une première fréquence d'échantillonnage $F_{ech1}$, avec $F_{éch1} > 2(F_{sup} - F_{inf})$. Le module de numérisation $202_1$ fournit une première numérisation provisoire $NP_1$ de la bande utile. Le module de numérisation $202_1$ peut en particulier être agencé pour réaliser l'étape 102 du procédé 100, sans perte de généralité.

Le dispositif 200 comprend un deuxième module de numérisation $202_2$, comprenant, ou consistant en, un échantillonneur bloqueur. Ce module de numérisation $202_2$ est configuré pour réaliser une numérisation de la bande utile à une deuxième fréquence d'échantillonnage $F_{ech2}$, avec $F_{éch2} > 2(F_{sup} - F_{inf})$ et $F_{ech2} \neq F_{ech1}$. Le module de numérisation $202_2$ fournit une deuxième numérisation provisoire $NP_2$ de la bande utile. Le module de numérisation $202_2$ peut en particulier être agencé pour réaliser l'étape 104 du procédé 100, sans perte de généralité.

Le dispositif 200 comprend en outre un premier module d'analyse $204_1$, pour analyser et fournir les fréquences des composantes se trouvant dans la première numérisation provisoire $NP_1$. Ce module d'analyse $204_1$ peut par exemple être, ou comprendre, un analyseur de fréquence. Ce module d'analyse $204_1$ fournit une liste, $LF_1$, des différentes fréquences se trouvant dans la première numérisation provisoire $NP_1$. Le module d'analyse $204_1$ peut en particulier être agencé pour réaliser l'étape 106 du procédé 100, sans perte de généralité.

Le dispositif 200 comprend un deuxième module d'analyse $204_2$, pour analyser et fournir les fréquences des composantes se trouvant dans la deuxième numérisation provisoire $NP_2$. Ce module d'analyse $204_2$ peut par exemple être, ou comprendre, un analyseur de fréquence. Ce module d'analyse $204_2$ fournit une liste, $LF_2$, des différentes fréquences se trouvant dans la deuxième numérisation provisoire $NP_1$. Le module d'analyse $204_2$ peut en particulier être agencé pour réaliser l'étape 108 du procédé 100, sans perte de généralité.

Le dispositif 200 comprend en outre un module de comparaison 206, pour analyser et fournir les fréquences communes, ou les fréquences non-communes, aux numérisations provisoires $NP_1$ et $NP_2$. Ce module de comparaison 206 peut être tout moyen de calcul configuré pour comparer les listes de fréquence $LF_1$ et $LF_2$. Le module de comparaison 206 peut en particulier être agencé pour réaliser l'étape 110 du procédé 100, sans perte de généralité.

Le dispositif 200 comprend un module 208 de génération d'une numérisation définitive, ND, de la bande utile, par exemple à partir de la deuxième numérisation provisoire NP₂. Ce module 208 peut être tout moyen de calcul configuré pour supprimer, dans la deuxième numérisation provisoire NP₂, toutes les fréquences qui apparaissent dans cette deuxième numérisation mais qui n'apparaissent pas dans la première numérisation provisoire. Le module 208 peut en particulier être agencé pour réaliser l'étape 112 du procédé 100, sans perte de généralité.

Alternativement, le module 208 peut générer la numérisation définitive ND de la bande utile à partir de la première numérisation provisoire NP₁.

De manière optionnelle, le dispositif 200 peut en outre comprendre un moyen de filtrage passe-bande 210, tel qu'un filtre passe-bande, pour sélectionner les signaux se trouvant dans la bande utile. Un tel moyen de filtrage 210 peut être positionné en amont des modules 202₁ et 202₂ et fournit auxdits modules les signaux analogiques de la bande utile à numériser.

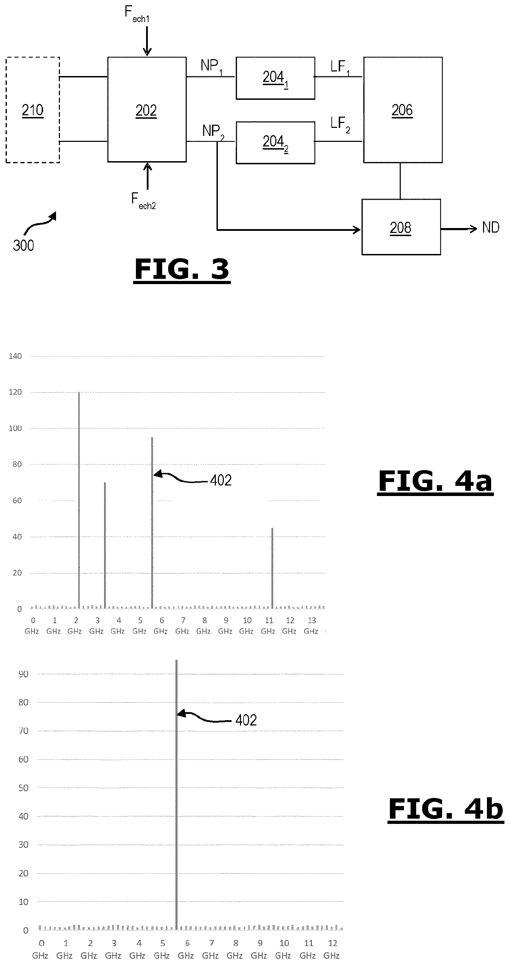

La FIGURE 3 est une représentation schématique d'un autre exemple de réalisation non limitatif d'un dispositif selon la présente invention.

Le dispositif 300 de la FIGURE 3 peut être utilisé pour mettre en œuvre tout procédé selon l'invention, et en particulier le procédé 100 de la FIGURE 1.

Le dispositif 300 comprend tous les éléments du dispositif 200 de la FIGURE 2 à l'exception des modules de numérisation 202₁ et 202₂. En effet, dans le dispositif 300, un seul et unique module de numérisation 202 est utilisé, à tour de rôle, pour obtenir le première numérisation provisoire NP₁ et ensuite la deuxième numérisation provisoire NP₂.

Dans les dispositifs 200 et 300, il est également possible d'utiliser un unique module d'analyse à la place des deux modules d'analyse 204₁ et 204₂. Dans ce cas, le module d'analyse est utilisé à tour de rôle pour analyser les composantes fréquentielles de la première numérisation provisoire NP₁ puis de la deuxième numérisation provisoire NP₂.

Au moins l'un des modules 202, 202₁, 202₂, 204₁, 204₂, 206 et 208 peut être une unité matérielle, tel qu'un serveur, un ordinateur, une tablette, un calculateur, un processeur, une puce informatique.

Au moins l'un des modules 202, 202₁, 202₂, 204₁, 204₂, 206 et 208 peut être une unité logicielle, tel qu'un programme d'ordinateur, une application, etc.

Au moins l'un des modules 202, 202₁, 202₂, 204₁, 204₂, 206 et 208 peut être une combinaison d'au moins un module logiciel et d'au moins un module matériel.

Au moins l'un des modules 202, 202₁, 202₂, 204₁, 204₂, 206 et 208 peut être un module individuel et indépendant des autres modules.

Au moins deux des modules 202, 202₁, 202₂, 204₁, 204₂, 206 et 208 peuvent être intégrés au sein d'un même module logiciel ou matériel.

Les FIGURES 4a-4e donnent un exemple non limitatif de numérisation d'une bande utile selon l'invention.

Dans l'exemple des FIGURES 4a-4e, la bande utile correspond à la bande 5GHz-9GHz.

Tel que montré en FIGURE 4a, les signaux comprennent un signal utile à 5,6 GHz qui se trouve dans la bande utile et des signaux hors bande utile à 2,2 GHz, 3,4 GHz et 11,2 GHz.

Un filtrage passe bande permet d'éliminer les signaux hors bande et ne conserver que le(s) signal(aux) se trouvant dans la bande utile, c'est-à-dire le signal à 5,6 GHz, tel que représenté en FIGURE 4b.

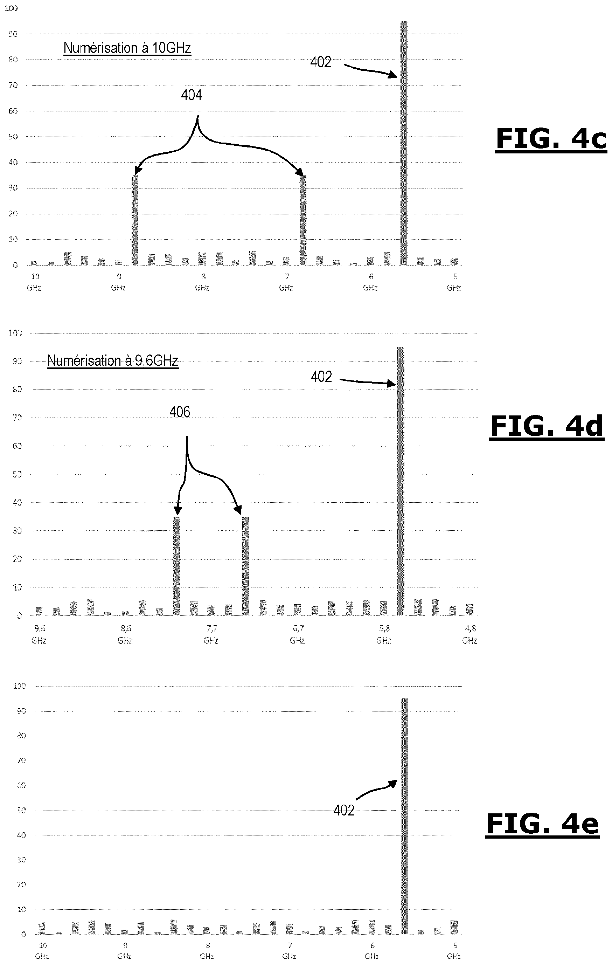

Un premier échantillonnage et numérisation à 10GHz permet d'obtenir une raie 402 à la fréquence 5,6GHz du signal utile et deux raies d'harmoniques repliés 404 aux fréquences de 6,8GHz et 8,8GHz, telles que représentées en FIGURE 4c.

Un deuxième échantillonnage et numérisation à 9,6 GHz permet d'obtenir une raie 402 à la fréquence 5,6GHz du signal utile et deux raies d'harmoniques repliés 406 aux fréquences de 8,2 GHz et 7,4 GHz, telles que représentées en FIGURE 4d.

En comparant les fréquences des raies dans les deux numérisations, on identifie la raie à la fréquence 5,6 GHz comme étant la seule composante fréquentielle qui est commune aux deux numérisations provisoires. Les raies 404 qui se trouvent dans la première numérisation ne se trouvent pas dans la deuxième numérisation et les raies 406 qui se trouvent dans la deuxième numérisation ne se trouvent pas dans la première numérisation. Par conséquent, les raies 404 et le raies 406 correspondant à des harmoniques créés lors des opérations d'échantillonnage et de numérisation de la bande utile et ne correspondent pas à des signaux analogiques réellement présents dans la bande utile.

La numérisation définitive de la bande utile ne comprend donc que la raie à la fréquence 5,6 GHz, telle que représentée en FIGURE 4e

Bien entendu l'invention n'est pas limitée aux exemples qui viennent d'être décrits.

**Revendications**

1. Procédé (100) numérisation de signaux se trouvant dans une bande de fréquences, dite bande utile, comprenant les étapes suivantes :

   - au moins deux numérisations (102,104) des signaux de ladite bande utile à des fréquences d'échantillonnage (F_{éch1},F_{éch2}) différentes pour obtenir deux numérisations provisoires (NP₁,NP₂) pour ladite bande utile, et
   - obtention (112) d'une numérisation définitive (ND) pour ladite bande utile en éliminant dans l'une desdites numérisations provisoires (NP₁,NP₂) chaque fréquence, ou raie de fréquence, qui n'apparait pas dans l'autre desdites numérisations provisoires (NP₁,NP₂).

**2.** Procédé (100) selon la revendication précédente, **caractérisé en ce qu'**il comprend une étape (114) de filtrage passe bande pour éliminer les signaux dont la fréquence ne se trouve pas dans la bande utile.

**3.** Procédé (100) selon l'une quelconque des revendications précédentes, **caractérisé en ce qu'**au moins une, en particulier chaque, fréquence d'échantillonnage ($F_{éch1}$,$F_{éch2}$) supérieure au double de la largeur ($F_{sup}$-$F_{inf}$) de la bande utile.

**4.** Procédé (100) selon l'une quelconque des revendications précédentes, **caractérisé en ce que** la différence entre les fréquences d'échantillonnage ($F_{éch1}$,$F_{éch2}$) est supérieure ou égale au pas de précision en fréquence des signaux numérisés de sorte à discriminer deux raies de fréquences différentes.

**5.** Programme d'ordinateur comprenant des instructions exécutables qui, lorsqu'elles sont exécutées par un appareil informatique, mettent en en œuvre toutes les étapes du procédé (100) de numérisation selon l'une quelconque des revendications précédentes.

**6.** Dispositif (200;300) de numérisation comprenant des moyens configurés pour mettre en œuvre toutes les étapes du procédé (100) de numérisation selon l'une quelconque des revendications 1 à 4.

**7.** Dispositif (300) selon la revendication précédente, **caractérisé en ce que** les numérisations sont réalisées par unique convertisseur analogique-numérique (202) utilisé à tour de rôle.

**8.** Dispositif (200) selon la revendication 6, **caractérisé en ce qu'**il comprend un convertisseur analogique numérique ($202_1$,$202_2$) pour chaque numérisation.

**9.** Dispositif (200;300) selon l'une quelconque des revendications 7 ou 8, **caractérisé en ce que** le, ou au moins un, convertisseur analogique numérique ($202_1$,$202_2$;202) comprend un échantillonneur bloqueur.

100

114 — Filtrage passe-bande

102 — Première numérisation de la bande utile, et mémorisation de la première numérisation provisoire

104 — Deuxième numérisation de la bande utile, et mémorisation de la deuxième numérisation provisoire

106 — Analyse de la première numérisation provisoire pour en détecter les composantes fréquentielles

108 — Analyse de la deuxième numérisation provisoire pour en détecter les composantes fréquentielles

110 — Identification des composantes fréquentielles communes aux deux numérisations provisoires

112 — Fourniture de la numérisation définitive des signaux

## FIG. 1

$F_{ech1}$

210

$202_1$ — $NP_1$ — $204_1$ — $LF_1$

$202_2$ — $NP_2$ — $204_2$ — $LF_2$

206

$F_{ech2}$

208 → ND

200

## FIG. 2

**FIG. 3**

**FIG. 4a**

**FIG. 4b**

Numérisation à 10GHz

402

404

**FIG. 4c**

Numérisation à 9,6GHz

402

406

**FIG. 4d**

402

**FIG. 4e**

Europäisches
Patentamt

European
Patent Office

Office européen
des brevets

**RAPPORT DE RECHERCHE EUROPEENNE**

Numéro de la demande

EP 22 30 6115

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | THOMAS MOON ET AL: "Low-cost high-speed pseudo-random bit sequence characterization using nonuniform periodic sampling in the presence of noise", VLSI TEST SYMPOSIUM (VTS), 2012 IEEE 30TH, IEEE, 23 avril 2012 (2012-04-23), pages 146-151, XP032453136, DOI: 10.1109/VTS.2012.6231094 ISBN: 978-1-4673-1073-4 * Section III; figures 1,2 * | 1-9 | INV. H03M1/12 |
| X | NICHOLAS TZOU ET AL: "Dual-frequency incoherent subsampling driven test response acquisition of spectrally sparse wideband signals with enhanced time resolution", VLSI TEST SYMPOSIUM (VTS), 2012 IEEE 30TH, IEEE, 23 avril 2012 (2012-04-23), pages 140-145, XP032453135, DOI: 10.1109/VTS.2012.6231093 ISBN: 978-1-4673-1073-4 * Section II; figures 1,2 * | 1,5,6 | |

DOMAINES TECHNIQUES RECHERCHES (IPC)

H03M

-----

-/--

Le présent rapport a été établi pour toutes les revendications

| Lieu de la recherche | Date d'achèvement de la recherche | Examinateur |
|---|---|---|
| La Haye | 16 janvier 2023 | Jesus, Paulo |

EPO FORM 1503 03.82 (P04C02)

page 1 de 2

Europäisches
Patentamt

European
Patent Office

Office européen
des brevets

# RAPPORT DE RECHERCHE EUROPEENNE

Numéro de la demande

**EP 22 30 6115**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | HYUN CHOI ET AL: "Signal Acquisition of High-Speed Periodic Signals Using Incoherent Sub-Sampling and Back-End Signal Reconstruction Algorithms", IEEE TRANSACTIONS ON VERY LARGE SCALE INTEGRATION (VLSI) SYSTEMS, IEEE SERVICE CENTER, PISCATAWAY, NJ, USA, vol. 19, no. 7, 1 juillet 2011 (2011-07-01), pages 1125-1135, XP011356884, ISSN: 1063-8210, DOI: 10.1109/TVLSI.2010.2048135 * Abstract; figure 2 * ----- | 1,5-7 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 16 janvier 2023 | Jesus, Paulo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**page 2 de 2**